(19) Europäisches Patentamt / European Patent Office / Office européen des brevets

(11) **EP 2 139 048 A1**

(12) **EUROPEAN PATENT APPLICATION**

(43) Date of publication:
**30.12.2009 Bulletin 2009/53**

(51) Int Cl.:
**H01L 31/055** (2006.01)  **H01L 31/0236** (2006.01)

(21) Application number: **08158762.8**

(22) Date of filing: **23.06.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicant: **Photon BV**
**3911 RW Rhenen (NL)**

(72) Inventor: **Slager, Ben**
**3911 RW Rhenen (NL)**

(74) Representative: **Oberlein, Gerriet H. R. et al**
**CPW GmbH**
**Kasinostraße 19-21**
**D-42103 Wuppertal (DE)**

(54) **Photovoltaic device with improved spectral response**

(57) Photovoltaic device comprising at least one active layer, a transparent cover plate, a layer that contains luminescent molecules and a layer which contains on at least one side an array of defined and repeating geometrical optical structures, **characterized in that** an individual geometrical optical structure of the array comprises a m-polygonal base and an apex area, said m-polygonal base and said apex area are connected by m surfaces with m being equal to 3 or higher.

Array of geometrical optical structures

Layer containing luminescent molecules

Glass cover

Active layer

Figure 1

EP 2 139 048 A1

**Description**

The invention pertains to a photovoltaic device with improved spectral response, which comprises a layer that contains luminescent molecules and a layer with on at least one of its surfaces an array of repeating geometrical optical structures.

Solar cells (photovoltaic cells) are commonly used to convert light energy into electrical energy. This effect is known as the photovoltaic effect. Solar cells contain an active layer which consists of a light absorbing material which generates charge carriers upon light exposure. An active layer which is commonly used in photovoltaic devices is silicon. However, a variety of materials can be encountered like for example gallium arsenide (GaAs), cadmium telluride (CdTe) or copper indium gallium diselenide (CIGS). The charges, which are generated in the active layer, are separated to conductive contacts that transmit electricity. Due to the thin and brittle nature of the active layer it is usually protected from external influences by a transparent cover plate (e.g. glass). This cover plate is positioned between the light source and the light receiving side of the active layer.

Most of the time, a single solar cell can not produce enough electricity for the desired purpose and the cells are therefore linked together to form a larger type of photovoltaic device. Assemblies of cells are used to make solar modules, which in turn may be linked into photovoltaic arrays. Individual cells can be used to power small devices such as calculators or electronic watches. Modules or photovoltaic arrays are for example encountered on the roof tops of houses or off-grid applications such as boats, traffic signs or spacecrafts.

The efficiency by which a photovoltaic device converts light into electricity depends on the wavelength of the incident light. The effect is known as "quantum efficiency". Commonly, photovoltaic devices have poor quantum efficiency towards highly energetic light such as ultraviolet (UV) or blue light. This reduced efficiency results partially from the absorption of these wavelengths by layers (e.g. cover plate, window layer) positioned between the active layer and the light source. As a result, this light does not reach the photovoltaic device and can not contribute to the production of electricity. One example of such a layer is the cover plate. Conventional glass cover plates are not transparent to most of the light with a wavelength below 360nm. Plastic cover plates are usually stabilized by UV absorbing compounds to prevent photo degradation, and consequently discoloration, of the plastic. A plastic cover is therefore not transparent to most of the wavelengths below 400nm.

Another effect that reduces the efficiency of photovoltaic devices to highly energetic light is the high absorption of these wavelengths by the active layer. As a result most of the highly energetic light is absorbed close to the surface on the light receiving side of the active layer. The concentration of imperfections within the active layer near the surface area is however relatively large. Charge carriers generated within this area can therefore easily recombine and charge carriers that recombine in the active layer do not contribute to the production of electricity.

Most solar cells also have a poor efficiency towards light with relatively low energy such as e.g. far infra-red light. When light is absorbed by the active layer, the energy of a photon is given to an electron. Due to this energy transfer the electron is freed from its immobile state (valance band) and put into mobile state (conduction band). The difference between these two energetic states or bands is known as the "band gap". To generate a (mobile) electron in the active layer it necessary to have a photon with an energy which is at least equal to the energy corresponding to the band gap. If the photon has less energy, such as far infrared light, it is not absorbed by the active layer and does not contribute to production of electricity.

From literature several methods are known to improve the low quantum efficiency of photovoltaic devices towards certain wavelengths.

An option is to apply an additional layer that contains down-converting luminescent molecules to the active layer of a photovoltaic device. (US3912931A1). The additional layer consists usually of a polymeric matrix material. The down-converting luminescent molecules are distributed within the matrix material and improve the spectral response of the photovoltaic device by converting highly energetic light (short wavelength) into light of low energy (long wavelength) that is more efficiently used by the active layer. These molecules convert the wavelength of light via an absorption/re-emission process during which a single high energy photon is absorbed and a single photon of lower energy is re-emitted. The layer containing the luminescent molecules is preferably positioned above any light absorbing layer that is present between the active layer and the light source. In this case the molecules can convert light that would be absorbed (and thus lost), to low energetic wavelengths that are transmitted through the absorbing layer. For example, a polymeric layer containing luminescent molecules can be applied on top of a glass cover of a photovoltaic device such that the UV light, which would normally be absorbed by the glass cover, is converted to lower energetic light that is not absorbed by the glass cover. In addition, these low energetic wavelengths are more uniformly absorbed throughout the active layer and suffer less from surface recombination effects. A layer containing luminescent molecules can thus improve the quantum efficiency of a photovoltaic device.

Unfortunately a part of the light emitted by the luminescent molecules is not absorbed by the active layer because it is emitted away from the active layer and/or trapped in the layer in which the molecules are distributed due to total internal reflection and/or it is reflected by the active layer. As a result, at least 30-40% of the light re-emitted by the luminescent molecules is not absorbed by the active layer.

In addition, the amount of light converted into another wavelength by a luminescent dye is related to the amount of light absorbed by said dye, which in its turn is related to the layer thickness and the dye concentration according to the Lamber-Beer law:

$$Absorbance = \varepsilon * [C] * l \qquad\qquad (1)$$

$\varepsilon$ = molar extinction coefficient in [L mol$^{-1}$ cm$^{-1}$]
[C] = concentration of dye in [mol L$^{-1}$]
l = layer thickness in [cm].

To ensure that most of the incident light is absorbed either $\varepsilon$, l or [C] has to be large. Since $\varepsilon$ is an intrinsic property of the dye and can not be altered, and [C] is limited since luminescent dyes have a limited solubility into a matrix materials such as polymers, it is thus neccesary to have a thick layer (I). Due to the thick layer required and high costs of the luminescent dyes itself these systems are relatively expensive.

To improve the spectral response of photovoltaic devices towards low energetic wavelengths such as far infra red light it is known to apply an additional layer, which contains so-called up-converting luminescent molecules, to one of the sides of the active layer. Such a luminescent molecule within said layer absorbs at least two low energy photons and re-emits a single photon of a higher energy. As a result a layer containing these molecules can enhance the quantum efficiency of a photovoltaic device towards low energetic light. The problems these systems encounter are similar to the systems which use down-converting luminescent molecules to improve the quantum efficiency of a photovoltaic device towards highly energetic light such as UV light. In addition the up-conversion process is an inefficient process and hence the obtained improvement in quantum efficiency is small. (A. Shalav, B.S. Richards and M.A. Green, Luminescent layers for enhanced silicon solar cell performance: Up-conversion, Solar Energy Materials and Solar Cells 2007, 91 (9), 829-842)

From the above it can be concluded that photovoltaic devices are inefficient to certain wavelengths. These wavelengths can be converted into wavelengths which are more efficiently used by photovoltaic device by applying a layer containing luminescent molecules to said device. These molecules can be down-converting to improve the quantum efficiency of a photovoltaic device towards highly energetic light such as UV light, or these molecules can be up-converting to improve the quantum efficiency of a photovoltaic device towards low energetic wavelengths such as far-IR light. A significant amount of light reemitted by the luminescent molecules is, however, not absorbed by the active layer and can therefore not contribute to the production of electricity. In addition these device are relatively expensive since large amounts of luminescent dyes and thick layers are required.

It is therefore an object of the present invention to overcome the above mentioned disadvantages of photovoltaic devices known in the art.

This object is achieved by a photovoltaic device comprising at least one active layer, a transparent cover plate, a layer that contains luminescent molecules and a layer which contains on at least one side an array of defined and repeating geometrical optical structures, **characterized in that** an individual geometrical optical structure of the array comprises a m-polygonal base and an apex area, said m-polygonal base and said apex area are connected by m surfaces with m being equal to 3 or higher.

The transparent cover plate, the luminescent molecule containing layer and the layer containing the repeating geometrical optical structures can be either single, separate layers or combined into one or two layers. For example the layer containing the luminescent molecules can also be the layer which contains the repeating geometrical optical structures. Another example is a cover plate which contains luminescent molecules and repeating geometrical optical structures.

The array of individual structures forms a relief structure. An individual structure of the array comprises an m-polygonal base and an apex area which are connected by m surfaces. Preferably an individual geometrical optical structure is further **characterized in that** at most 2 of the m surfaces which connect the apex to the base should be n-polygonal shaped with n being equal to 4 or higher. The apex area is defined as the upper part of an individual geometrical optical structure to which the surfaces which are connected to the base combine. The apex area can be a point (e.g. as encountered in a pyramid or cone) or a line (e.g. as encountered in a groove). Examples of a single structure of the array of geometrical optical structures are pyramids with a triangular base, pyramids with a rectangular base, cones, v-shaped grooves, tilted V-grooves or a sawtooth profile.

In a preferred embodiment of the invention m is extremely large and be considered as being equal to infinite. In this particular case an individual geometrical optical structure of the array exhibits an at least partially rounded cross section. Such a geometrical optical structure may be in the shape of a cone.

The apex area may also be a surface which is parallel to the m-polygonal base of the individual geometrical optical structure. Examples of such a single structure of the array of geometrical optical structures are cylinders with a circular cross section or cupola shaped structures.

Not encompassed in the scope of the present invention is a photovoltaic device with an array of defined and repeating geometrical optical structures in which the individual geometrical optical structures comprise a base and a single apex which are connected by at least 3 n-polygonal surfaces where n is equal to 4 or higher.

Although the photovoltaic device could contain only one individual geometrical optical structure it is preferred that it contains an array of defined and repeating geometrical structures, i.e. a relief structure. An array is to be understood as collection or group of elements, in this case individual geometrical optical structures, placed adjacent to each other in a random or arranged setup. Preferably the array contains at least 4 geometrical relief structures.

The photovoltaic device according to the present invention exhibits an improved spectral response. The array of defined and repeating geometrical optical structures traps the light re-emitted by the luminescent molecules such that it enhances the absorption of said light by the photovoltaic device. The array of geometrical structures can also redirect the light incident to the layer such that the path length of said light into the layer containing the luminescent molecules is increased. As a result a lower concentration of luminescent molecules and a thinner layer can be used, which reduces the costs.

The use of geometrical optical structures for photovoltaic devices is known. The geometrical optical structures improve the efficiency of a photovoltaic device by reducing the reflection losses of incident light. Most efficiently the geometrical optical structures are applied directly to the front and/or back of the active layer. This requires however expensive processing and the use of toxic chemicals. Alternatively, geometrical optical structures are applied to the glass front cover (U. Blieske, T. Doege, P. Gayou, M. Neander, D. Neumann, A. Pra, Light-trapping in solar modules using extra-white textured glass, 3rd World Conference on Photovoltaic Energy Conversion May 2003**)** or a polymeric layer on top of the front cover (Jianhua Zhao, Aihua Wang, Patrick Campbell, Martin A. Green, 22.7% Efficient Silicon Photovoltaic Modules with Textured Front Surface, IEEE transactions of electron devices 1999, 46 (7), 1495-1497). However, the reflection losses are less efficiently reduced when the geometrical optical structures are applied to the front cover or separate polymeric layer than when these structures are applied to the active layer. It is also known that surface relief structures can be used to concentrate the light such that the solar cells area can be reduced.

It is also known in the art that v-shaped (G.A. Landis, 21st IEEE photovoltaic specialist conference, 1304-1307 (1990)) or pyramidal structures as disclosed in WO 03/046617 are applied to a glass plate to reduce the reflection losses of said plate and hence increase its transmission. The structures can be applied to the glass plate via for example casting or pressing.

Independent of the setup, the current use of geometrical optical structures in photovoltaics is related to the reduction of reflection losses of light incident to the photovoltaic device or to the concentrating of light to minimize the surface area of solar cells. In the current invention, relief structures enhance the effect of luminescent molecules distributed into a layer which is part of the photovoltaic device. The effect of luminescent molecules is enhanced by trapping the light emitted by the luminescent molecules and increasing the path length of light incident to the photovoltaic device such that lower concentrations of luminescent molecules and thinner layers are required. The invention therefore also pertains to the use of luminescent molecules in combination with an array of defined and repeating geometrical optical structures to improve the spectral response of a photovoltaic device.

The geometrical optical structures can be made of any transparent materials which are preferably polymeric, however also ceramic materials can be used. Examples of polymeric materials are: polycarbonate, polymethylmethacrylate, polypropylene, polyethylene, polyamide, polyacrylamide, or any combinations thereof. An example of a ceramic material is glass. A transparent material is to be understood as a material which has a linear absorption of less than 0.2 mm$^{-1}$ within the range of 400-1200 nm.

The luminescent molecules are preferably photo-luminescent molecules and can for example be fluorescent or phosphorescent. Photo-luminescent molecules are luminescent molecules which emit light due to the excitation of said molecules by incident light. Other types of luminescent molecules are for example molecules which emit light due to action of heat (incandescence), the action of an electrical current/field (electro-luminescent), from the action of chemicals (chemoluminescent) or from the action of sound (sono-luminescent). Photo-luminescent molecules can be both down-conversion luminescent and up-conversion luminescent. The preferred molecules are fluorescent and can for example be any perelyne, coumarin, rhodamine, naphthalimide, benzoxanthene, acridine, auramine,benzanthrone, cyanine, stilbene, rubrene, leciferin or derivatives thereof. Fluorescent molecules are **characterized in that** the time between the absorption and emission of a photon is relatively short. Typically the time between absorption and emission is less than 1 second. Alternatively it is also possible to use phosphorescent molecules that have a relatively long time of up to several hours between absorption and emission of a photon.

The luminescent dye containing the luminescent molecules is thus preferably an organic dye. The luminescent dye may, however, also be an inorganic dye.

In a preffered embodiment of the invention the luminescent molecules are homogeniously mixed into a matrix material. It is however also possible that the luminescent molecules are non-homogeniously mixed into the matrix

EP 2 139 048 A1

material. Alternatively it is possible that the molecules are positioned in only a part of the matrix material. For example the luminescent molecules might be positioned into sphere like particles which are mixed into the matrix material.

The luminescent molecules may comprise a mixture of several luminescent molecules. The concentration of the luminescent molecules preferably lies between 0.001 and 50 gram per $m^2$ cover plate surface and per mm layer thickness of the matrix in which the molecules are distributed. In case the layer in which the molecules are distributed contains a relief structure on one or more of the surfaces, the average layer thickness should be taken and the $m^2$ surface area should be taken as the surface area of a similar cover plate without surface relief.

In a preferred embodiment of the invention the luminescent molecules are distributed into one or more layers which are positioned between the active layer of photovoltaic device and the incident light. In another preferred embodiment of the invention such a layer can be a separate layer which is placed on top of the active layer or the cover plate. Alternatively the luminescent molecules are distributed into the array of geometrical optical structures or in a separate layer on top of the said array. The layer that contains the luminescent molecules may therefore contain on at least one side the array of defined and repeating geometrical optical structures. It is also possible that the transparent cover plate is the layer that contains the luminescent molecules. In a most preferred embodiment the transparent cover plate is the layer that contains the luminescent molecules and the transparent cover plate is the layer that contains on at least one side an array of defined and repeating geometrical optical structures.

Although it is possible that the layer which contains the luminescent molecules is made of inorganic materials such as glass, the layer is preferably of organic and more preferably polymeric nature.

The array of geometrical optical structures can be coated with an additional layer such as an anti-fouling coating or scratch resistance coating. It is also possible that the array of geometrical optical structures is coated with a second layer which has a different refractive index than the layer comprising the array of geometrical optical structures. In a preferred embodiment said array may be coated such that the top of coating layer is flat. In this case the structures can be considered as being "filled" by the additional coating.

The invention is further illustrated in more detail by means of the following figures

Figure 1:    Schematic representation of a photovoltaic device according to the invention
Figure 2:    Schematic representation of the improved spectral response
Figure 3:    Examples for individual defined geometrical optical structures
Figure 4:    Examples for arrays of defined and repeating geometrical optical structures
Figure 5:    Schematic representation of the location of the layer containing the luminescent dye

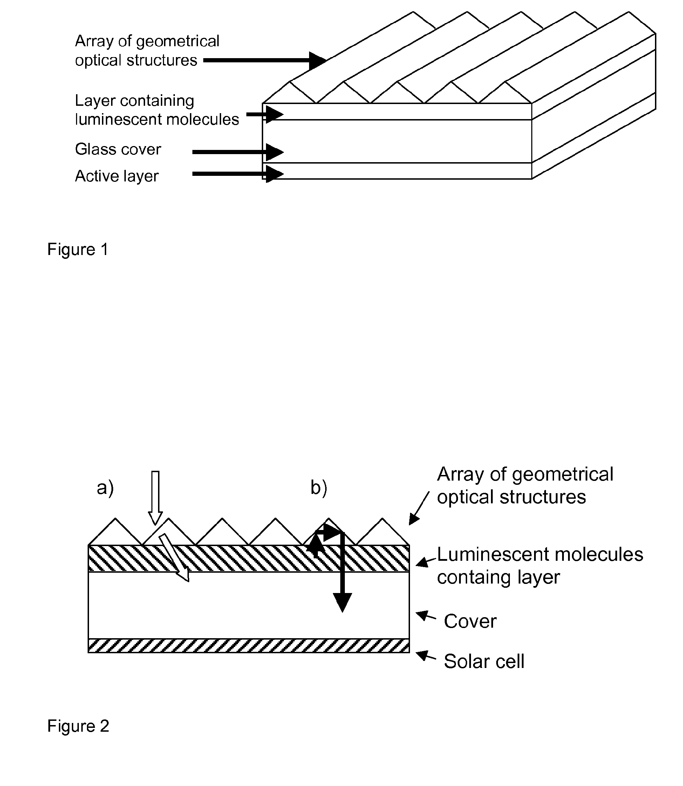

Figure 1 shows a schematic representation of an example of a photovoltaic device according to the invention. The photovoltaic device with improved spectral response as shown in figure 1 comprises an active layer, a cover layer on top of the active layer, a layer that contains luminescent molecules and on at least one of the surfaces of the device an array of defined and repeating geometrical optical structures.

Figure 2 shows how the array of geometrical optical structures can redirect the light incident to the layer such that the path length of said light into the layer containing the luminescent molecules is increased (a). The array of geometrical features traps the light re-emitted by the luminescent molecules such that it enhances the absorption of said light by the photovoltaic device (b).

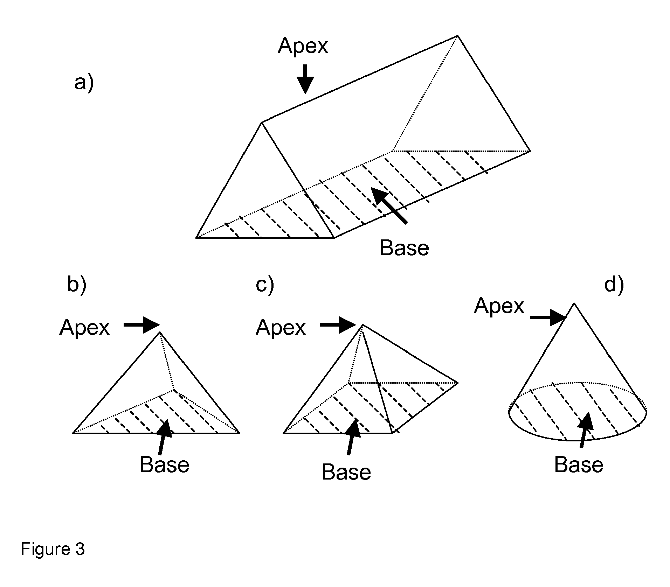

Figure 3 shows examples of individual geometrical structures of which the array may consist. Figure 3 a, b, c shows individual structures that consist of an n-polygonal base and an apex area being a point or a line which are connected by n surfaces. The apex area is defined as the upper part of a relief structure to which the surfaces, which are connected to the base, combine. An apex can be a point (e.g. as encountered in a pyramid or cone) or a line (e.g. as encountered in a groove). Figure 3 d shows an individual geometrical structure with a rounded cross section that is also encompassed in the scope of the present invention.

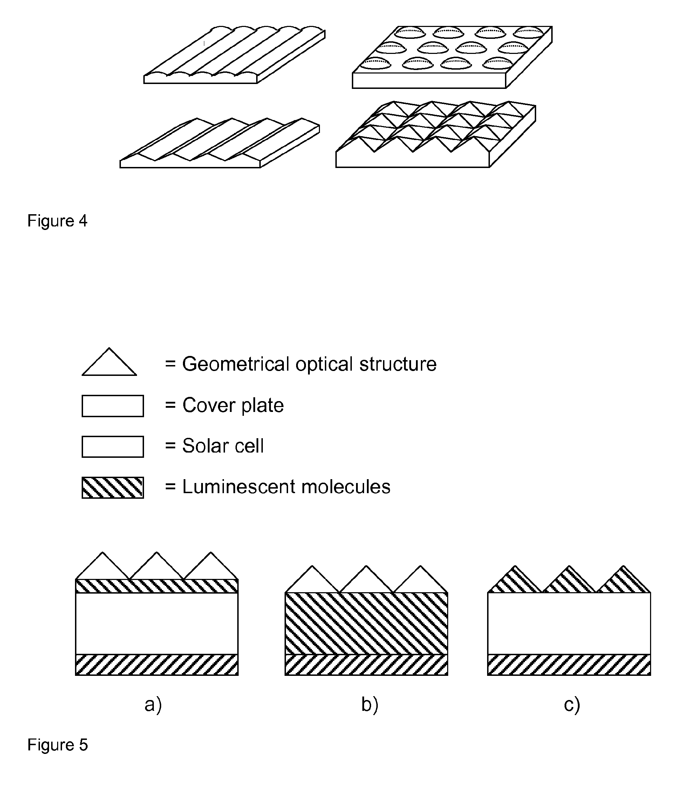

Figure 4 shows examples of arrays of geometrical optical structures. An array is to be understood as collection or group of elements, in this case individual geometrical optical structures, placed adjacent to each other in a random or arranged setup.

Figure 5 shows examples of different positions of the luminescent molecules in the photovoltaic device. The luminescent molecules can for example be distributed into a separate layer below the array of geometrical optical structures (a), or can be distributed into the cover plate (b) or into the optical structures themselves (c).

**Claims**

1. Photovoltaic device comprising at least one active layer, a transparent cover plate, a layer that contains luminescent molecules and a layer which contains on at least one side an array of defined and repeating geometrical optical structures, **characterized in that** an individual geometrical optical structure of the array comprises a m-polygonal base and an apex area, said m-polygonal base and said apex area are connected by m surfaces with m being equal to 3 or higher.

2. Photovoltaic device according to claim 1, **characterized in that** the apex area is a point or a line.

3. Photovoltaic device according to claim 2, **characterized in that** the array are chosen from the group comprising v-shaped grooves, sawtooth-shaped grooves, pyramids with a triangular base, pyramids with a rectangular base or cones.

4. Photovoltaic device according to claim 1, **characterized in that** the apex area is a surface which is parallel to the m-polygonal base.

5. Photovoltaic device according to claim 4, **characterized in that** the array comprises structures in the shape of a cupola or cylinder with circular cross section.

6. Photovoltaic device according to any one of claims 1 to 5, **characterized in that** the transparent cover plate is the layer that contains the luminescent molecules.

7. Photovoltaic device according to any one of claims 1 to 6, **characterized in that** the layer that contains the luminescent molecules also contains on at least one side an array of defined and repeating geometrical optical structures.

8. Photovoltaic device according to any one of claims 1 to 6, **characterized in that** the transparent cover plate is the layer that contains the luminescent molecules and that the transparent cover plate is the layer that contains on at least one side an array of defined and repeating geometrical optical structures.

9. Photovoltaic device according to any one of claims 1 to 8, **characterized in that** the surface of the array of defined and repeating geometrical optical structures contains an additional coating or layer.

10. Photovoltaic device according to any one of claims 1 to 9, **characterized in that** the luminescent molecules comprise a mixture of several different luminescent molecules.

11. Photovoltaic device according to any one of claims 1 to 10, **characterized in that** the concentration of luminescent molecules (s) is between 0.001 and 50 gram/m$^2$/mm layer thickness.

12. Photovoltaic device according to any one of claims 1 to 11, **characterized in that** the layer comprising the array of defined and repeating geometrical optical structures is made of a polymer or a mixture of more than one polymers.

13. Photovoltaic device according to any one of claims 1 to 12, **characterized in that** the luminescent molecules are organic.

14. Photovoltaic device according to any one of claims 1 to 12, **characterized in that** the luminescent molecules are inorganic.

15. Use of luminescent molecules in combination with an array of defined and repeating geometrical optical structures to improve the spectral response of a photovoltaic device.

Array of geometrical optical structures

Layer containing luminescent molecules

Glass cover

Active layer

Figure 1

a) b)

Array of geometrical optical structures

Luminescent molecules containg layer

Cover

Solar cell

Figure 2

a)

Apex

Base

b)

Apex

Base

c)

Apex

Base

d)

Apex

Base

Figure 3

Figure 4

△ = Geometrical optical structure

☐ = Cover plate

☐ = Solar cell

▨ = Luminescent molecules

a)                    b)                    c)

Figure 5

Europäisches
Patentamt

European
Patent Office

Office européen
des brevets

**EUROPEAN SEARCH REPORT**

Application Number

EP 08 15 8762

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 29 24 045 A1 (STANDARD ELEKTRIK LORENZ AG) 18 December 1980 (1980-12-18) * the whole document * ----- | 1-4,6-15 | INV. H01L31/055 H01L31/0236 |
| X | JP 2004 297025 A (SCIENCE UNIV OF TOKYO) 21 October 2004 (2004-10-21) * figure 3b * ----- | 1-4,6-9, 12-15 | |
| X | US 4 153 813 A (BLIEDEN HARRY R ET AL) 8 May 1979 (1979-05-08) * figure 4 * ----- | 1,2,4,5 | |
| X | EP 0 012 217 A (IBM [US]) 25 June 1980 (1980-06-25) * figure 3 * ----- | 1-4,6-9, 13-15 | |
| X | JP 57 152172 A (TEIJIN LTD) 20 September 1982 (1982-09-20) * abstract * ----- | 1,5 | |
| A | MARUYAMA T ET AL: "Transformations of the wavelength of the light incident upon solar cells" 1 October 2001 (2001-10-01), SOLAR ENERGY MATERIALS AND SOLAR CELLS, ELSEVIER SCIENCE PUBLISHERS, AMSTERDAM, NL, PAGE(S) 207 - 216 , XP004274188 ISSN: 0927-0248 * figure 1 * ----- | 1-15 | TECHNICAL FIELDS SEARCHED (IPC) H01L |
| A | DE 199 54 954 A1 (HNE ELEKTRONIK GMBH & CO SATEL [DE]) 23 May 2001 (2001-05-23) * the whole document * ----- | 1-15 | |

The present search report has been drawn up for all claims

| Place of search | Date of completion of the search | Examiner |
|---|---|---|
| Berlin | 30 January 2009 | Le Meur, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 08 15 8762

This annex lists the patent family members relating to the patent documents cited in the above-mentioned European search report.
The members are as contained in the European Patent Office EDP file on
The European Patent Office is in no way liable for these particulars which are merely given for the purpose of information.

30-01-2009

| Patent document cited in search report | | | Publication date | Patent family member(s) | | Publication date |
|---|---|---|---|---|---|---|
| DE 2924045 | | A1 | 18-12-1980 | NONE | | |
| JP 2004297025 | | A | 21-10-2004 | NONE | | |
| US 4153813 | | A | 08-05-1979 | NONE | | |
| EP 0012217 | | A | 25-06-1980 | BR 7908181 A | | 09-09-1980 |
| | | | | CA 1136745 A1 | | 30-11-1982 |
| | | | | DE 2964744 D1 | | 17-03-1983 |
| | | | | IT 1164529 B | | 15-04-1987 |
| | | | | JP 55082471 A | | 21-06-1980 |
| | | | | US 4202704 A | | 13-05-1980 |
| JP 57152172 | | A | 20-09-1982 | NONE | | |
| DE 19954954 | | A1 | 23-05-2001 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 3912931 A1

- WO 03046617 A

**Non-patent literature cited in the description**

- **A. Shalav ; B.S. Richards ; M.A. Green.** Luminescent layers for enhanced silicon solar cell performance: Up-conversion. *Solar Energy Materials and Solar Cells,* 2007, vol. 91 (9), 829-842
- **U. Blieske ; T. Doege ; P. Gayou ; M. Neander ; D. Neumann ; A. Pra.** Light-trapping in solar modules using extra-white textured glass. *3rd World Conference on Photovoltaic Energy Conversion,* May 2003

- **Jianhua Zhao ; Aihua Wang ; Patrick Campbell ; Martin A. Green.** 22.7% Efficient Silicon Photovoltaic Modules with Textured Front Surface. *IEEE transactions of electron devices,* 1999, vol. 46 (7), 1495-1497
- **G.A. Landis.** *21st IEEE photovoltaic specialist conference,* 1990, 1304-1307